# EUROPÄISCHE PATENTSCHRIFT

(11) **EP 1 533 622 B1**
(45) Veröffentlichungstag und Bekanntmachung des Hinweises auf die Patenterteilung: **08.03.2006**
(21) Anmeldenummer: 03360128.7
(22) Anmeldetag: 18.11.2003
(51) Int. Cl.: G01R 31/02

(54) **Verfahren zur Adernschlusserkennung**
Method for detecting short circuit between conductors
Procédé de détection de court-circuit entre les conducteurs

(43) Veröffentlichungstag der Anmeldung: 25.05.2005
(73) Patentinhaber: ALCATEL, 75008 Paris (FR)
(72) Erfinder: Klose, Bernd, 71679 Asperg (DE)
(74) Vertreter: Rausch, Gabriele

(56) Entgegenhaltungen:
- DE-A- 10 134 745
- GB-A- 1 447 256
- US-A- 5 414 343

## Beschreibung

### Stand der Technik

Die Erfindung betrifft ein Verfahren zur Adernschlussüberwachung zwischen Adern unterschiedlicher Mehrdrahtleitungen, die in einem gemeinsamen Kabel geführt sind.

Mehrere Mehrdrahtleitungen können gemeinsam in einem Kabel geführt werden. Dies bedeutet, dass die Mehrdrahtleitungen benachbart zueinander angeordnet sind. Kommt es zu einer Beschädigung des Kabels, kann es zu Kurzschlüssen zwischen Adern verschiedener Mehrdrahtleitungen kommen. Derartige Kurzschlüsse werden als Adernschlüsse bezeichnet. Bei vielen Anwendungen können derartige Adernschlüsse zu gefährlichen Situationen führen.

Mehrdrahtleitungen, insbesondere Vierdrahtleitungen, werden häufig verwendet, um eine Weichensteuerung mit einem Weichenantrieb zu verbinden. Häufig sind mehrere Weichensteuerungen in einem Baugruppenträger angeordnet, so dass die Vierdrahtleitungen in einem gemeinsamen Kabel zur Weiche geführt-werden können. Wenn Adernschlüsse in Kabeln zwischen Weichensteuerungen und Weichenantrieben auftreten, kann es zum fehlerhaften Stellen von Weichen kommen, was in Zugunfällen resultieren kann. Deshalb muss sichergestellt sein, dass es nicht zu fehlerhaften Weichenumstellungen auf Grund von Adernschlüssen kommt.

Bestimmte Kombinationen von Adernschlüssen zwischen Adern verschiedener Vierdrahtleitungen, d.h. von Steuerleitungen von zwei oder mehreren Weichen, zeigen sich erst bei einer Weichenumsteltung. Deshalb ist es bekannt, einen Zyklus zu verwenden, in dem Weichen mindestens einmal umgestellt werden müssen. Allerdings ist es möglich, dass innerhalb eines Zyklus Adernschlüsse eine Störungsmeldung verhindern. Dies bedeutet, dass ein erster Fehler von einem zweiten Fehler überdeckt wird und eine Störungsmeldung auf Grund eines Adernschlusses nicht ausgegeben wird. Außerdem wird ein Zyklus in der Regel nur einmal am Tag durchgeführt. Es kann daher bis zu 24 Stunden dauern, bis ein Adernschluss detektiert wird.

Aus der US 5 027 074 ist eine Kabelprüfvorrichtung für die Prüfung der einzelnen Leiter eines Mehrdrahtkabels bekannt geworden. Die Kabelprüfvorrichtung weist einen Übermittler zum Anschluß an ein Ende des Kabels und einen Empfänger zum Anschluß an das gegenüberliegende Ende des Kabels auf. Der Übermittler sendet Spannungsimpulsfolgen durch jeden Leiter des Kabels zum Empfänger Der Empfänger überwacht diese Impulse am gegenüberliegenden Ende des Kabels und ermittelt die vorhandenen Kurzchlüsse zwischen Leitern des Kabels, wenn zwei Leiter gleichzeitig Spannungsimpulse erzeugen.

### Aufgabe der Erfindung

Aufgabe der Erfindung ist es, ein Verfahren zur Adernschlussüberwachung zu schaffen, mit dem Adernschlüsse schnell und zuverlässig erkannt werden können.

### Gegenstand der Erfindung

Gelöst wird diese Aufgabe erfindungsgemäß durch ein Verfahren gemäß Anspruch 1, bei dem jeder Mehrdrahtleitung eine gepulste Überwachungsspannung mit einer anderen Impulsfolge zugeführt wird und überwacht wird, ob in der Mehrdrahtleitung während einer Pausenzeit zwischen zwei Impulsen ein Strom fließt.

Als Pausenzeit wird dabei die Zeit zwischen zwei Überwachungsspannungsimpulsen bezeichnet. Wenn jede Mehrdrahtleitung mit einer Überwachungsspannung unterschiedlicher Impulsfolge gespeist wird und ein Adernschluss zwischen zwei oder mehreren Mehrdrahtleitungen auftritt, fließt in mindestens einer der Mehrdrahtleitungen ein Strom während einer Pausenzeit, d.h. wenn in dieser Mehrdrahtleitung eigentlich kein Strom fließen sollte. Dieser Stromfluss wird detektiert und eine Störung wird gemeldet. Diese Art der Adernschlussüberwachung kann außerhalb der Umschaltvorgänge einer Weiche dauernd in Betrieb sein. Dies bedeutet, dass ein Adernschluss innerhalb kürzester Zeit, insbesondere innerhalb von Sekunden, erkannt werden und anschließend behoben werden kann. Die Erkennungszeit von Adernschlüssen von bis zu 24 Stunden wird dadurch erheblich reduziert. Außerdem werden Störungsmeldungen auf Grund von Adernschlüssen nicht mehr verhindert. Die Sicherheit von Weichen wird erhöht. Als weiterer Vorteil ist zu nennen, dass der Umstellzyklus von Weichen in deutlich größeren Abständen erfolgen kann oder gänzlich entfallen kann.

Weiterhin ermöglicht das erfindungsgemäße Verfahren den Einsatz von Überspannungsschutzelementen bei Weichen. In den in der Eisenbahntechnik verwendeten langen Kabeln kann es zur Einkopplung von Spannungen kommen, beispielsweise bei Blitzschlag oder bei einem Kurzschluss in der Fahrleitung. Es ist wünschenswert, derartige Überspannungen gegen Erde abzuleiten. Dies ist im Stand der Technik nicht möglich, da es bei einer Ableitung gegen Erde von jeder Leitung bei zwei benachbarten Leitungen zu einem Kurzschluss und damit zu einer Überbrückung der Überwachungskontakte kommen kann. Dies bedeutet, dass im Stand der Technik eine Adernschlussüberwachung nicht möglich ist, wenn Überspannungsschutzelemente vorgesehen sind. Wird eine Adernschlussüberwachung mit dem erfindungsgemäß Verfahren durchgeführt, so kann die Adernschlussüberwachung auch sichergestellt werden, wenn Überspannungsschutzelemente eingesetzt werden.

Bei einer bevorzugten Verfahrensvariante kann vorgesehen sein, dass die Impulsfolgen sich in der Pulsweite, d.h. in der Einschaltdauer der Überwachungsspannung, in der Pausendauer, in der Frequenz oder im Puls-/Pausenverhältnis unterscheiden. Es kann vorgesehen sein, dass alle Mehrdrahtleitungen mit einer Überwachungsspannung derselben Frequenz aber unterschiedlicher Einschaltdauer gespeist werden. Es kann jedoch auch vorgesehen sein, dass jeder Mehrdrahtleitung vollständig unterschiedliche lmpulsfolgen zugeführt werden, insbesondere solche, die sich in Einschaltdauer, Pausendauer, Frequenz oder in der Pulsweite unterscheiden.

Ein besonders bevorzugtes Einsatzgebiet des Verfahrens zur Adernschlussüberwachung ist die Überwachung von Adernschlüssen zwischen Vierdrahtleitungen, insbesondere von Vierdrahtleitungen zwischen Weichensteuerungen und Weichenantrieben. Insbesondere kann die Adernschlussüberwachung eingeschaltet werden, wenn sich eine Weiche in einer Endlage befindet und ausgeschaltet werden, während die Weiche umgestellt wird.

Bei einer vorteilhaften Verfahrensvariante wird die Impulsfolge abhängig von einer Nummer eines Steckplatzes eines Baugruppenträgers, auf dem eine mit einer Mehrdrahtleitung verbundene Baugruppe angeordnet ist, bestimmt. Dies ermöglicht, die Impulsfolge automatisch zu generieren. Jeder Steckplatz eines Baugruppenträgers kann binär kodiert sein. Wird eine Baugruppe auf einen entsprechenden Steckplatz aufgesetzt, kann ausgehend von der Nummer des Steckplatzes eine Impulsfolge generiert werden. Als Baugruppe kommt beispielsweise eine Weichensteuerung in Frage.

Bei einer besonders bevorzugten Weiterbildung der Verfahrensvariante kann vorgesehen sein, dass die Pausenzeit einer Impulsfolge abhängig von der Nummer des Steckplatzes des Baugruppenträgers, auf dem die mit einer Mehrdrahtleitung verbundene Baugruppe angeordnet ist, bestimmt wird. Dabei kann jeder Steckplatznummer des Baugruppenträgers eine Pausenzeit zugeordnet sein. Alternativ kann ausgehend von der Steckplatznummer eine Pausenzeit berechnet oder anderweitig bestimmt werden.

Besonders bevorzugt ist es, wenn die Pausenzeit ermittelt wird als die Summe eines vorgegebenen Pausenwerts in Millisekunden und der Nummer des Steckplatzes in Millisekunden. Es versteht sich, dass auch andere Zeiteinheiten verwendet werden können. Beispielsweise kann vorgesehen sein, dass ein Pausenwert von 200 ms vorgegeben wird und die Nummer des Steckplatzes in Millisekunden addiert wird. Der Steckplatz 1 hätte demnach eine Pausenzeit von 201 ms und der Steckplatz 12 eine Pausenzeit 212 ms. Wird zudem eine Pulsdauer für die Überwachungsspannung von 20 ms vorgegeben, so ist bei Adernschlüssen zwischen benachbarten Vierdrahtleitungen nach maximal 20 Impulsen oder ca. 4 Sekunden ein so deutlicher Versatz der Überwachungsstromimpulse feststellbar, dass in der Pausenzeit ein Überwachungsstrom fließt. Dies bedeutet, dass im Beispiels bereits nach 4 Sekunden ein Adernschluss erkannt werden kann.

Bei einer weiteren Verfahrensvariante kann vorgesehen sein, dass die Impulsfolge abhängig von der Nummer eines Baugruppenträgers bestimmt wird. Somit können unterschiedlichen Baugruppenträgern unterschiedliche Impulsfolgen zugeordnet werden. Dies kann weiterhin kombiniert werden mit der Möglichkeit, die Impulsfolge abhängig von der Nummer des Steckplatzes des Baugruppenträgers zu bestimmen. Dies bedeutet, dass die Impulsfolge zunächst in einer Abhängigkeit vom Baugruppenträger und außerdem in einer Abhängigkeit vom Steckplatz bestimmt wird. Beispielsweise kann einem ersten Baugruppenträger eine Pausenzeit von 100 ms und einem zweiten Baugruppenträger eine Pausenzeit von 200 ms zugeordnet werden. Weiterhin kann zu der baugruppenträgerspezifischen Pausenzeit die Nummer des Steckplatzes beispielsweise in Millisekunden addiert werden.

Wenn die Adernschlussüberwachung für jede Mehrdrahtleitung von einem zugeordneten Doppelrechnersystem gesteuert wird, kann ein Adernschluss auf signaltechnisch sichere Weise detektiert werden. Die Rechner beaufschlagen zusammen die Mehrdrahtleitung und damit einen Überwachungsschaltkreis mit der Überwachungsspannung. Wenn nur einer der Rechner des Doppelrechnersystems einen Überwachungsstrom während einer Pausenzeit im Überwachungsschaltkreis detektiert, wird eine Störung gemeldet.

Die Aufgabe wird außerdem gelöst durch eine Anordnung zum Durchführen einer Adernschlussüberwachung mit Mitteln zum Speisen eines Überwachungsschaltkeis, der eine Mehrdrahtleitung und eine Überwachungseinrichtung umfasst, mit einer gepulsten Überwachungsspannung, wobei die Überwachungseinrichtung Mittel zum Überprüfen, ob während einer Pausenzeit ein Strom im Überwachungsschaltkreis fließt, aufweist. Die Mittel zum Speisen mit einer gepulsten Überwachungsspannung und die Überwachungseinrichtung können mit zwei Rechnern, insbesondere zwei Mikrocontrollern, in Verbindung stehen. Die Mikrokontroller können beispielsweise eine Stellwerkspannung von 60V pulsen und detektieren, ob zeitgleich mit einem Pulssignal ein Strom in der Überwachungseinrichtung fließt. Das Pulsen der Stellwerkspannung kann dabei insbesondere erfolgen, indem ein Schalter im Überwachungsstromkreis durch je eine Ausgabeleitung jedes Mikrokontrollers gesteuert wird, wobei die Ausgabeleitungen durch logisch UND verknüpft sind. Die Ein- und Ausschaltzeiten werden durch die Programmierung der Mikrokontroller bestimmt.

Weitere Merkmale und Vorteile der Erfindung ergeben sich aus der nachfolgenden Beschreibung eines Ausführungsbeispiels der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

### Zeichnung

Ein Ausführungsbeispiel ist in der schematischen Zeichnung dargestellt und wird in der nachfolgenden Beschreibung erläutert. Es zeigt:
- **Fig. 1**: eine stark schematisierte Darstellung eines elektronischen Stellwerks zur Erläuterung des Verfahrens zur Adernschlusserkennung;
- **Fig. 2**: eine Darstellung eines Überwachungsschaltkreises.

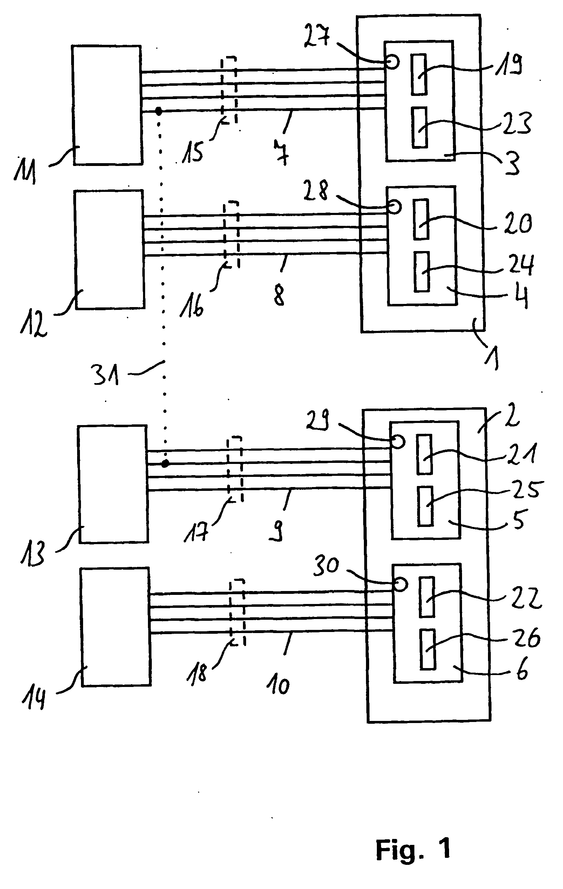

**Fig. 1** zeigt zwei Baugruppenträger **1, 2**, die im Ausführungsbeispiel jeweils zwei Weichensteuerungen **3 - 6** als Baugruppen aufweisen. Jede der Weichensteuerungen **3 - 6** ist über eine Vierdrahtleitung **7 - 10** mit einem Weichenantrieb **11 - 14** verbunden. Mit gestrichelten Linien sind Vierdrahtschnittstellen **15 - 18** dargestellt. Jede Weichensteuerung **3 - 6** weist ein Doppelrechnersystem, bestehend aus einem ersten als Mikrocontroller ausgebildeten Rechner **19** - **22** und einem zweiten als Mikrocontroller ausgebildeten Rechner **23 - 26** auf. Wenn die Weichenantriebe 11 - 14 nicht zum Umstellen einer Weiche benötigt werden, wird von den Doppelrechnersystemen eine Überwachungsspannung auf die Vierdrahtleitungen 7 - 10 gegeben. Diese Überwachungsspannung ist gepulst, wobei sich die Impulsfolge aus der Nummer des Steckplatzes einer Weichensteuerung 3 - 6 und der Nummer des Baugruppenträgers 1, 2 ergibt. Die Weichensteuerung 3 befindet sich beispielsweise im ersten Steckplatz des ersten Baugruppenträgers 1. Die Weichensteuerung 6 befindet sich im zweiten Steckplatz des zweiten Baugruppenträgers 2. Wenn dem ersten Baugruppenträger 1 eine Grundpausenzeit von 150 ms zugeordnet ist und dem zweiten Baugruppenträger 2 eine Grundpausenzeit von 200 ms zugeordnet ist und der jeweils erste Steckplatz die Grundpausenzeit um 1 ms und der zweite Steckplatz die Grundpausenzeit um 2 ms verlängert, weist die Überwachungsspannung der Weichensteuerung 3 eine Pausenzeit von 151 ms und die Überwachungsspannung der Weichensteuerung 6 eine Pausenzeit von 202 ms auf. In einer Überwachungseinrichtung **27 - 30** wird überwacht, ob ein Strom in einem Überwachungskreis fließt, obwohl von dem Doppelrechnersystem der zugeordneten Weichensteuerung 3 - 6 gerade kein Überwachungsspannungsimpuls gegeben wird. Wird beispielsweise in der Überwachungseinrichtung 27 ein Strom während einer Pausenzeit detektiert, deutet dies auf einen Adernschluss zweier Adern von unterschiedlichen Vierdrahtleitungen 7 - 10 hin. Ein solcher Adernschluss ist beispielhaft durch die punktierte Linie **31** dargestellt. Wegen der unterschiedlichen Impulsfolge in der Vierdrahtleitung 7 und der Vierdrahtleitung 9 tritt ein Strom während einer Pausenzeit in der Überwachungseinrichtung 27 und/oder der Überwachungseinrichtung 29 auf. Ist dies der Fall, so wird eine Störungsmeldung ausgegeben, insbesondere an das jeweils zugeordnete Doppelrechnersystem.

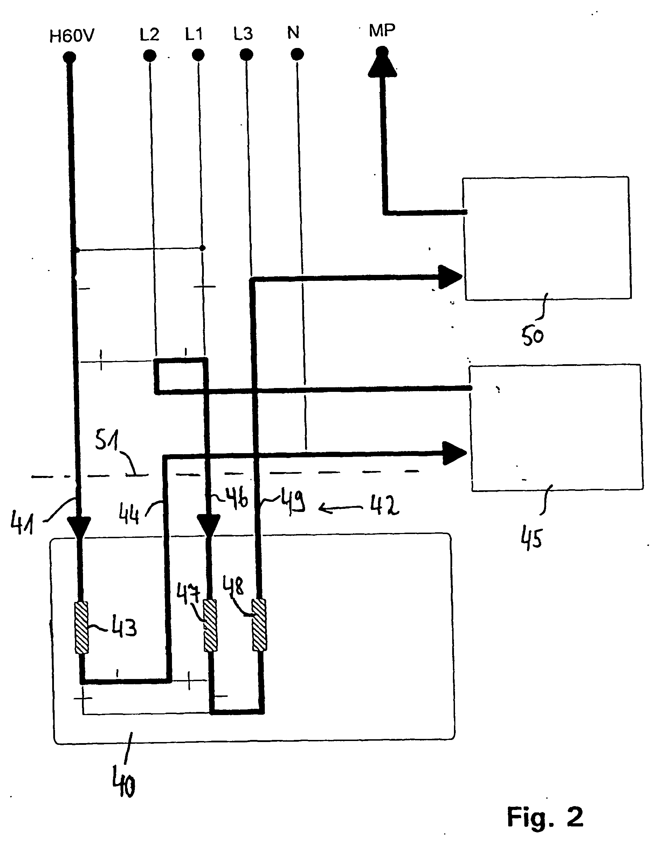

In der **Fig. 2** ist der Stromfluss während der Überwachung einer Vierdrahtleitung am Beispiel eines Weichenantriebs **40** dargestellt. Eine gepulste Überwachungsspannung H60V wird an eine erste Ader **41** einer Vierdrahtleitung **42** angelegt, so dass ein Strom durch eine erste Motorwicklung **43** des Weichenantriebs 40 fließt und von dort über eine zweite Ader **44** in eine Überwachungseinrichtung **45** fließt. Über eine dritte Ader **46** wird der Strom der zweiten Motorwicklung **47** zugeführt und von dort in die Motorwicklung **48** geführt. Über die vierte Ader **49** gelangt der Strom in einen Auffahrstromkreis **50,** in dem erkannt wird, ob eine Weiche aufgefahren ist, zur Stelle MP (Batterieminus). Der beschriebene Stromkreis von H60V bis zu MP stellt einen Überwachungsstromkreis dar. In der Überwachungseinrichtung 45, die mit einem Doppelrechnersystem in Verbindung steht, wird überwacht, ob während einer Pausenzeit ein Strom im Überwachungsstromkreis fließt. Dies ist beispielsweise dann der Fall, wenn ein Adernschluss zwischen der Ader 41 und einer Ader einer benachbarten Vierdrahtleitung besteht. Es ist anzumerken, dass die Komponenten, die oberhalb der gestrichelten Linie **51** dargestellt sind, in einer Weichensteuerung angeordnet sind.

## Patentansprüche

1. Verfahren zur Adernschlussüberwachung zwischen Adern (41, 44, 46, 49) unterschiedlicher Mehrdrahtleitungen (7-10); die in einem gemeinsamen Kabel geführt sind, **dadurch gekennzeichnet, dass** jeder Mehrdrahtieitung eine gepulste Überwachungsspannung mit einer anderen Impulsfolge zugeführt wird und überwacht wird, ob in mindestens einer der Mehrdrahtleitungen während einer Pausenzeit zwischen zwei Impulsen ein Strom fließt und ein Adernschluss (31) erkannt wird, wenn ein Strom in einer Pausenzeit fließt.

2. Verfahren nach Anspruch 1, **dadurch gekennzeichnet, dass** die Impulsfolgen sich in der Pulsweite, in der Pausendauer, in der Frequenz oder im Puls-/Pausenverhältnis unterscheiden.

3. Verfahren nach Anspruch 1, **dadurch gekennzeichnet, dass** der Adernschluss (31) zwischen Vierdrahtleitungen (7 - 10; 42), insbesondere Vierdrahtleitungen (7 -10; 42) zwischen einer Weichensteuerung (3 - 6) und einem Weichenantrieb (11 -14, 40) überwacht wird.

4. Verfahren nach Anspruch 1, **dadurch gekennzeichnet, dass** die Impulsfolge abhängig von einer Nummer eines Steckplatzes eines Baugruppenträgers (1, 2), auf dem eine mit einer Mehrdrahtleitung verbundene Baugruppe (3 - 6) angeordnet ist, bestimmt wird.

5. Verfahren nach Anspruch 4, **dadurch gekennzeichnet, dass** die Pausenzeit einer Impulsfolge abhängig von der Nummer des Steckplatzes des Baugruppenträgers (1, 2), auf dem die mit einer Mehrdrahtleitung verbundene Baugruppe (3 - 6) angeordnet ist, bestimmt wird.

6. Verfahren nach Anspruch 5, **dadurch gekennzeichnet, dass** die Pausenzeit ermittelt wird als die Summe eines vorgegebenen Pausenwerts in Millisekunden und der Nummer des Steckplatzes in Millisekunden.

7. Verfahren nach Anspruch 1, **dadurch gekennzeichnet, dass** die Impulsfolge abhängig von der Nummer eines Baugruppenträgers (1, 2) bestimmt wird.

8. Verfahren nach Anspruch 1, **dadurch gekennzeichnet, dass** die Adernschlussüberwachung für jede Mehrdrahtleitung von einem zugeordneten Doppelrechnersystem gesteuert wird.

9. Anordnung zum Durchführen des Verfahrens nach Anspruch 1, mit Mitteln zum Speisen eines Überwachungsschaltkreises mit einer gepulsten Überwachungsspannung, wobei der überwachungsschaltkreis eine Mehrdrahtleitung (42) und eine Überwachungseinrichtung (45) umfasst, und die Überwachungseinrichtung Mittel zum Überprüfen, ob während einer Pausenzeit ein einen Adernschluss abbildender Strom im überwachungsschaltkreis fließt, aufweist.

10. Anordnung nach Anspruch 9, **dadurch gekennzeichnet, dass** die Mittel zum Speisen des Überwachungsschaltkreises mit einer gepulsten Oberwachungsspannung und die Überwachungseinrichtung (45) mit zwei Rechnern, insbesondere zwei Mikrocontrollern, in Verbindung stehen.

## Revendications

1. Procédé pour la surveillance des courts-circuits entre les conducteurs (41, 44, 46, 49) de différentes lignes multifilaires (7 - 10) qui sont acheminées dans un câble commun, **caractérisé en ce qu'**une tension de surveillance impulsionnelle ayant une séquence d'impulsions différente est acheminée à chaque ligne multifilaire et on surveille si un courant circule dans l'une des ligne multifilaires pendant un temps de pause entre deux impulsions et un court-circuit entre conducteurs (31) est détecté si un courant circule pendant un temps de pause.

2. Procédé selon la revendication 1, **caractérisé en ce que** les séquences d'impulsions se différentient au niveau de la largeur des impulsions, de la durée de pause, de la fréquence ou du rapport impulsion/pause.

3. Procédé selon la revendication 1, **caractérisé en ce que** le court-circuit entre conducteurs (31) est surveillé entre des lignes à quatre fils (7 - 10 ; 42), notamment des lignes à quatre fils (7 - 10 ; 42) entre une commande d'aiguillage (3 - 6) et un mécanisme de manoeuvre d'aiguillage (11 - 14, 40).

4. Procédé selon la revendication 1, **caractérisé en ce que** la séquence d'impulsions est déterminée en fonction d'un numéro d'un emplacement d'un porte-module (1, 2) sur lequel est monté un module (3 - 6) relié à une ligne multifilaire.

5. Procédé selon la revendication 4, **caractérisé en ce que** le temps de pause d'une séquence d'impulsions est déterminé en fonction du numéro de l'emplacement du porte-module (1, 2) sur lequel est monté le module (3 - 6) relié à une ligne multifilaire.

6. Procédé selon la revendication 5, **caractérisé en ce que** le temps de pause est déterminé comme étant la somme d'une valeur de pause prédéfinie en millisecondes et le numéro de l'emplacement en millisecondes.

7. Procédé selon la revendication 1, **caractérisé en ce que** la séquence d'impulsions est déterminée en fonction du numéro d'un porte-module (1, 2).

8. Procédé selon la revendication 1, **caractérisé en ce que** la surveillance des courts-circuits entre conducteurs de chaque ligne multifilaire est commandée par un système à double calculateur associé.

9. Arrangement destiné à mettre en oeuvre le procédé selon la revendication 1, comprenant des moyens pour alimenter un circuit de surveillance avec une tension de surveillance impulsionnelle, le circuit de surveillance comprenant une ligne multifilaire (42) et un dispositif de surveillance (45), et le dispositif de surveillance présentant des moyens pour vérifier si un courant représentant un court-circuit entre conducteurs circule dans le circuit de surveillance pendant un temps de pause.

10. Arrangement selon la revendication 9, **caractérisé en ce que** les moyens d'alimentation du circuit de surveillance avec une tension de surveillance impulsionnelle et le dispositif de surveillance (45) sont reliés à deux calculateurs, notamment à deux microcontrôleurs.

## Claims

1. Method for monitoring intercore shorting between cores (41, 44, 46, 49) of different multiwire lines (7-10) which are fed through a common cable, **characterised in that** each multiwire line is supplied with a pulsed monitoring voltage having a different pulse sequence and is monitored as to whether a current flows in at least one of the multiwire lines during a pause time between two pulses, and an intercore short (31) is identified if a current flows in a pause time.

2. Method according to Claim 1, **characterised in that** the pulsed sequences differ by pulse width, pulse duration, frequency and/or pulse/pause ratio.

3. Method according to Claim 1, **characterised in that** the intercore shorting (31) is monitored between four-wire lines (7-10; 42), in particular four-wire lines (7-10; 42) between a rail point controller (3-6) and a rail point drive (11-14, 40).

4. Method according to Claim 1, **characterised in that** the pulse sequence is determined as a function of a number of a slot location of a module rack (1, 2), on which a module (3-6) connected to a multiwire line is arranged.

5. Method according to Claim 4, **characterised in that** the pause time of a pulse sequence is determined as a function of the number of the slot location of the module rack (1, 2), on which the module (3-6) connected to a multiwire line is arranged.

6. Method according to Claim 5, **characterised in that** the pause time is determined as the sum of a predetermined pause value in milliseconds and the number of the slot location in milliseconds.

7. Method according to Claim 1, **characterised in that** the pulse sequence is determined as a function of the number of a module rack (1, 2).

8. Method according to Claim 1, **characterised in that** the monitoring of the intercore shorting for each multiwire line is controlled by an associated double computer system.

9. Arrangement for carrying out the method according to claim 1, having means for supplying a monitoring circuit with a pulsed monitoring voltage, the monitoring circuit comprising a multiwire line (42) and a monitoring device (45), and the monitoring device having means for checking whether a current showing that there is a conductor short-circuit flows in the monitoring circuit during a pause time.

10. Arrangement according to Claim 9, **characterised in that** the means for supplying the monitoring circuit with a pulsed monitoring voltage and the monitoring device (45) are connected to two computers, in particular two microcontrollers.
